# EUROPEAN PATENT SPECIFICATION

(11) **EP 2 293 143 B1**
(45) Date of publication and mention of the grant of the patent: **02.09.2015**
(21) Application number: 10163283.4
(22) Date of filing: 19.05.2010
(51) Int. Cl.: G03F 7/039

(54) **Novel photoresist compositions**
Neue Fotoresistzusammensetzungen
Nouvelles compositions de résines photosensibles

(30) Priority: 20.05.2009 US 216660 P
(43) Date of publication of application: 09.03.2011
(73) Proprietor: Rohm and Haas Electronic Materials, LLC, Marlborough, Massachusetts 01752 (US)
(72) Inventor: Liu, Cong, Shrewsbury, MA 01545 (US); Xu, Cheng-Bai, Southboro, MA 01772 (US)
(74) Representative: Kent, Venetia Katherine

(56) References cited:
- EP-A1- 1 148 044
- JP-A- 2002 030 114
- US-A1- 2001 051 741
- US-A1- 2003 198 891

## Description

This application claims the benefit of priority under 35 U.S.C. §119(e) to U.S. Provisional Application No. 61/216,660, filed May 20, 2009.

The present invention relates to photoresist compositions that contain a resin that comprises one or more multi-ring, multi-cyclic ester units. Preferred photoresists comprise such resins and are chemically-amplified positive-tone compositions that can be effectively imaged with sub-200 nm radiation such as 193 nm radiation.

Photoresists are photosensitive films used for transfer of images to a substrate. A coating layer of a photoresist is formed on a substrate and the photoresist layer is then exposed through a photomask to a source of activating radiation. The photomask has areas that are opaque to activating radiation and other areas that are transparent to activating radiation. Exposure to activating radiation provides a photoinduced chemical transformation of the photoresist coating to thereby transfer the pattern of the photomask to the photoresist-coated substrate. Following exposure, the photoresist is developed to provide a relief image that permits selective processing of a substrate.

A photoresist can be either positive-acting or negative-acting. For most negative-acting photoresists, those coating layer portions that are exposed to activating radiation polymerize or crosslink in a reaction between a photoactive compound and polymerizable reagents of the photoresist composition. Consequently, the exposed coating portions are rendered less soluble in a developer solution than unexposed portions. For a positive-acting photoresist, exposed portions are rendered more soluble in a developer solution while areas not exposed remain comparatively less developer soluble. See U.S. 6586157.

While currently available photoresists are suitable for many applications, current resists also can exhibit significant shortcomings, particularly in high performance applications such as formation of highly resolved sub-half micron and sub-quarter micron features.

For instance, a persistent shortcoming of current resists is poor resolution of "isolated" resist lines or other features, particularly when using a positive resist. A developed resist line or other feature is generally considered "isolated" if it is spaced from the closest adjacent resist feature a distance equal to two or more times the line width. Thus, e.g., if a line is printed at a 0.25 µm width, that line would be considered isolated (rather than dense) if the next adjacent resist feature was spaced at least about 0.50 microns from the line. Common resolution problems with isolated lines include rounded tops and undercutting.

In one aspect, we now provide a photoresist composition as defined in claim 1 which comprises a resin having one or more polymerized units or structure VIIA. Such polymerized multi-ring ester units of structure VIIA preferably undergo photoacid-induced cleavage during lithographic processing (exposure, post-exposure bake) of a photoresist comprising the resin.

We have found that incorporation of such ester units into a polymer can provide significant improvements in lithographic performance of a photoresist containing the polymer. Among other things, photoresists comprising a resin having multi-ring ester groups as defined in claim 1 can exhibit good pattern collapse margins and enhanced depth of focus isolated line performance. Relief images of photoresists of the invention also can exhibit good resistance to plasma etchants. Still further, the multi-ring ester groups of structure VIIA can function as acid-labile leaving groups with comparatively lower activation energies.

While not being bound by any theory, it is thought that the bulky leaving group (i.e. the multi-cyclic group) liberated lithographic processing (i.e. photoacid-induced cleavage of the group) can create more free volume within the resist layer which in turn can promote greater desired mobility of the photoacid in exposed resist regions, while the bulky leavings groups that remain in unexposed regions can inhibit undesired diffusion of photoacid into such exposed resist layer regions, thereby enhancing contrast and lithographic results. That is, it is believed the relatively large steric size of the leaving group can impart high dissolution contrast to the resist.

Additionally, it is believed that the presence of a second branch point (i.e. second ring that does not undergo photoacid-induced cleavage) can reduce the recombination rate of the leaving group thereby increasing photospeed and/or reducing processing temperature (i.e. post-exposure bake temperature).

As referred to herein, a "multi-ring, multi-cyclic ester" compound, unit, group or other designations indicates an ester moiety as defined in formula VIIA of claim 1.

The compound forming the polymerized multi-ring, multi-cyclic ester units of the resin of the invention is of the structure VIIA 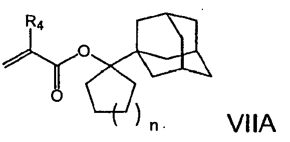 wherein n is an integer of 0 to 7; and R₄ represents hydrogen, straight, branched or cyclic monovalent hydrocarbon group of 1 to 6 carbon atoms.

Preferred resins of the invention comprise repeat units in addition to multi-cyclic ester units, particularly non-aromatic units such as provided by polymerization of an acrylate or an optionally substituted cyclic olefin such as a polymerized optionally substituted norbornene. Such additional resin units also may comprise a photoacid-labile moiety such as a photoacid-labile ester or acetal moiety. Other preferred resin include hetero-substituted carbocyclic aryl groups such as hydroxyl naphthyl groups. In at least certain aspects, particularly preferred resins are substantially free of any aromatic moieties, or at least substantially free of aromatic groups other than hydroxyl naphthyl groups.

Additional preferred polymer units may be provided by polymerization of an anhydride such as maleic anhydride or itaconic anhydride; or lactones such as provided by polymerization of a suitable acrylate e.g. acryloxy-norbornane-butyrolactone and the like.

Photoresists of the invention preferably comprise one or more photoacid generator compounds (PAGs) as a photoactive component. Preferred PAGs for use in resists of the invention include onium salt compounds including iodonium and sulfonium compounds; and non-ionic PAGs such as imidosulfonate compounds, N-sulfonyloxyimide compounds; diazosulfonyl compounds and other sulfone PAGS including α ,α-methylenedisulfones, disulfonehydrazines and disulfonylamine salts; nitrobenzyl compounds, halogenated particularly fluorinated non-ionic PAGS.

Photoresists of the invention also may contain a blend of resins, where at least one of the resins contains multi-ring, aromatic and/or multi-cyclic ester groups.

The invention is a photoresist composition as defined in claim 1. (i.e. capable of forming a relief image upon lithographic processing including patternwise exposure to activating radiation; optionally thermal treatment; development).

The invention also includes methods for forming relief images, including methods for forming a highly resolved relief image such as a pattern of lines (dense or isolated) where each line has vertical or essentially vertical sidewalls and a line width of about 0.40 microns or less, or even about 0.25, 0.20, 0.15, or 0.10 microns or less. In such methods, preferably a coating layer of a photoresist composition of the invention is imaged with short-wavelength radiation, particularly sub-200 nm radiation, especially 193 nm radiation, and higher energy radiation having a wavelength of less than 100 nm, and otherwise high energy radiation such as EUV, electron beam, ion beam or x-ray.

As discussed above, resins of the invention may comprise a variety of groups in addition to comprise multi-ring, multi-cyclic ester unit.

In one aspect, preferred additional units of resins of the invention include hetero-substituted (particularly hydroxy and thio) carbocyclic aryl moieties such as hydroxy naphthyl groups. References herein to a hetero-substituted carbocyclic aryl group means that the carbocyclic group has one or more, typically one, two or three, ring substituents that contain a hetero atoms, particularly oxygen or sulfur. That is, such references to "hetero-substituted" designate moieties that contain one or more hetero atoms, particularly one or two oxygen and/or sulfur atoms, that are ring substituents of the carbocyclic aryl group.

References herein to hydroxy naphthyl groups or other similar term means a naphthyl group that has at least one hydroxy ring substituent. The naphthyl group may suitably have more than one hydroxy group, such as two or three hydroxy ring substituents, although it is generally preferred that the naphthyl group contain a single hydroxy substituent.

Preferred substituted hetero-substituted carbocyclic aryl units for incorporation into a resin are naphthyl groups as well as other substituted carbocyclic aryl moieties such as hetero-substituted phenyl, anthracenyl, acenaphthyl, phenanthryl, and the like. Generally, hetero-substituted carbocyclic aryl groups having multiple fused rings (e.g. 2 or 3 fused rings, at least one of which is a carbocyclic aryl) are preferred such as hetero-substituted naphthyl, anthracenyl, acenaphthyl, phenanthryl, and the like.

A carbocyclic group may have a variety of hetero-substituents, with oxygen- and sulfur-containing substituents being generally preferred. For instance, preferred hetero-substituted carbocyclic aryl groups of resins of the invention include those aryl groups having one or more hydroxy (-OH), thio (-SH), alcohol (e.g. hydroxyC₁₋₆alkyl), thioalkyl (e.g. HSC₁₋₆alkyl), alkanoyl (e.g. C₁₋₆alkanoyl such as formyl or acyl), alkylsulfide such as C₁₋₆alkylsulfide, carboxylate (including C₁₋₁₂ester), alkyl ether including C₁₋₈ether, and the like. Preferably, at least one hetero atom of the hetero-containing substituent has a hydrogen substituent (e.g. hydroxy is preferred over alkoxy). It is also preferred that the hetero group has the hetero atom directly linked to the carbocyclic ring (such as a hydroxy or thio ring substituents), or a hetero atom is a substituent of an activated carbon such as a ring substituent of -CH₂OH or -CH₂SH, or other primary hydroxy or thio alkyl.

A resin of the invention may suitably contain a relatively wide range of amounts of hydroxy naphthyl units or other hetero-substituted carbocyclic aryl groups. Good lithographic results can be realized with use of a polymer that contains quite minor amounts of the hydroxy naphthyl units. For example, a polymer of the invention may suitably contain less than about 50 or 40 mole percent of hetero-substituted carbocyclic aryl units based on total units of a resin, or even less than about 30, 20, 15 or 10 mole percent of hetero-substituted carbocyclic aryl units based on total units of the polymer. Indeed, a polymer of the invention may suitably contain about 0.5, 1, 2, 3, 4, 5, 6, 7 or 8 mole percent of hydroxy naphthyl units based on total units of the resin.

Resins of the invention employed in photoresists imaged at 193 nm and suitably will be substantially free of any phenyl or other aromatic groups other than the hetero-substituted carbocyclic aryl units. For example, preferred resins of the invention employed for such short wavelength imaging contain less than about 5 mole percent aromatic groups other than the hetero-substituted carbocyclic aryl units, more preferably less than about 1 or 2 mole percent aromatic groups hetero-substituted carbocyclic aryl units.

A resin of the invention also may comprise a variety of other units. Preferred additional units include polymerized acrylate and cyclic olefin groups. Particularly preferred are such units that contain photoacid-labile groups such as photoacid-labile ester or acetal groups. For example, a resin may suitably contain polymerized *tert*-butyl acrylate, *tert*-butyl methacrylate, methyladmantyl acrylate, and/or methyladamantyl methacrylate units, and the like. Unless otherwise specified, referenced herein to acrylate groups or compounds are inclusive of substituted acrylate compounds such as methacrylate compounds.

Preferred polymerized acrylate groups may include an alicyclic group. As referred to herein, the term "alicyclic leaving group" of a resin means the following: an alicyclic group that is covalently bound to a polymer, and when such a polymer is formulated in a photoresist containing the polymer and a photoactive component (particularly one or more photoacid generators), the alicyclic group can be or is cleaved from the polymer (i.e. covalent bond to the polymer cleaved) upon exposure to acid generated upon exposure of a coating layer of the photoresist to activating radiation (e.g. 193 nm), typically with post-exposure thermal treatment (e.g. 90°C or greater for 0.5, 1 or more minutes).

An alicyclic acrylate compound contains a vinyl ester, where the ester moiety is an alicyclic group such as methyl adamantyl and the like. The vinyl group suitably may be substituted, particularly at the alpha-vinyl carbon such as by optionally substituted C₁₋₈alkyl (e.g. -CH₃, CF₃, -CH₂OH, -CH₂CH₂OH and other halo particularly floruo and hydroxyl alkyl) and thus includes methacrylates.

Preferred polymers include those that contain alkyl acrylate units, particularly where the acrylate group contains an alicyclic moiety. Also preferred are polymers that contain a carbon alicyclic group such as norbornyl fused to the polymer backbone.

Preferred polymers also may contain lactone units, such as lactones that are moieties of a polymerized acrylate, or other lactone polymerized from other unsaturated molecule. Polymer units containing alpha-butyrolactone groups are suitable.

Preferred polymers of the invention contain 2, 3, 4 or 5 distinct repeat units, i.e. preferred are copolymers, terpolymers, tetrapolymers and pentapolymers that contain one or more multi-ring, multi-cyclic ester groups as disclosed herein.

Polymers of the invention are preferably employed in photoresists imaged at 193 nm, and thus preferably will be substantially free of any phenyl or other aromatic groups other than the hetero-substituted carbocyclic aryl units. For example, preferred polymers contain less than about 5 mole percent aromatic groups other than the hetero-substituted carbocyclic aryl units, more preferably less than about 1 or 2 mole percent aromatic groups hetero-substituted carbocyclic aryl units.

As discussed above, resins of the invention may comprise photoacid-labile groups in addition to a multi-ring, multi-cyclic ester group of the polymerized unit of structure VIIA. Such additional photoacid-labile groups include photoacid-labile ester groups are often preferred such as a tert-butyl ester, or an ester containing a tertiary alicyclic group. Such photoacid-labile esters may be directly pendant from a carbon alicyclic, heteroalicyclic or other polymer unit (e.g. where the photoacid-labile group is of the formula -C(=O)OR, where R is tert-butyl or other non-cyclic alkyl group, or a tertiary alicyclic group and is directly linked to the polymer unit), or the ester moieties may be spaced from a heteroalicyclic or carbon alicyclic polymer unit, e.g. by an optionally alkylene linkage (e.g. -(CH₂)₁₋₈C(=O)OR, where R is tert-butyl or other non-cyclic alkyl group, or a tertiary alicyclic group). Such photoacid-labile groups also suitably may be contain fluorine substitution at available positions.

Preferred additional photoacid-labile ester groups contain a tertiary alicyclic hydrocarbon ester moiety. Preferred tertiary alicyclic hydrocarbon ester moieties are polycyclic groups such adamantyl, norbornyl, ethylfencyl, cyclopantane or a tricyclo decanyl moiety. References herein to a "tertiary alicyclic ester group" or other similar term indicate that a tertiary alicyclic ring carbon is covalently linked to the ester oxygen, i.e.-C(=O)O-TR' where T is a tertiary ring carbon of alicyclic group R'. In at least many cases, preferably a tertiary ring carbon of the alicyclic moiety will be covalently linked to the ester oxygen, such as exemplified by the below-depicted specifically preferred polymers. However, the tertiary carbon linked to the ester oxygen also can be exocyclic to the alicyclic ring, typically where the alicyclic ring is one of the substituents of the exocyclic tertiary carbon. Typically, the tertiary carbon linked to the ester oxygen will be substituted by the alicyclic ring itself, and/or one, two or three alkyl groups having 1 to about 12 carbons, more typically 1 to about 8 carbons, even more typically 1, 2, 3 or 4 carbons. The alicyclic group also preferably will not contain aromatic substitution. The alicyclic groups may be suitably monocyclic, or polycyclic, particularly bicyclic or tricyclic groups.

Preferred alicyclic moieties (e.g. group TR' of -C(=O)O-TR') of photoacid labile ester groups of polymers of the invention have rather large volume. It has been found that such bulky alicyclic groups can provide enhanced resolution when used in copolymers of the invention.

Polymers of the invention also may contain photoacid-labile groups that do not contain an alicyclic moiety. For example, polymers of the invention may contain photoacid-labile ester units, such as a photoacid-labile alkyl ester. Generally, the carboxyl oxygen (i.e. the carboxyl oxygen as underlined as follows: -C(=O)O) of the photoacid-labile ester will be covalently linked to the quaternary carbon. Branched photoacid-labile esters are generally preferred such as t-butyl and -C(CH₃)₂CH(CH₃)₂.

In this regard, as discussed above, polymers used in photoresist compositions of the invention may contain distinct photoacid-labile groups, i.e. the polymer may contain two or more ester groups that have distinct ester moiety substitutions e.g. one ester may have an alicyclic moiety and another ester may have an acyclic moiety such as t-butyl, or the polymer may contain both ester and other functional groups that are photoacid-labile such as acetals, ketals and/or ethers.

As discussed, various moieties of resin units may be optionally substituted. A "substituted" substituent may be substituted at one or more available positions, typically 1, 2, or 3 positions by one or more suitable groups such as e.g. halogen (particularly F, Cl or Br); cyano; C₁₋₈ alkyl; C₁₋₈ alkoxy; C₁₋₈ alkylthio; C₁₋₈ alkylsulfonyl; C₂₋₈ alkenyl; C₂₋₈ alkynyl; hydroxyl; nitro; alkanoyl such as a C₁₋₆ alkanoyl e.g. acyl and the like; etc.

Preferred alkanoyl groups will have one or more keto groups, such as groups of the formula -C(=O)R" where R" is hydrogen or C₁₋₈ alkyl.

Polymers of the invention can be prepared by a variety of methods. One suitable method is an addition reaction which may include free radical polymerization, e.g., by reaction of selected monomers to provide the various units as discussed above in the presence of a radical initiator under an inert atmosphere (e.g., N₂ or argon) and at elevated temperatures such as about 60°C or greater, although reaction temperatures may vary depending on the reactivity of the particular reagents employed and the boiling point of the reaction solvent (if a solvent is employed). Suitable reaction solvents include e.g. tetrahydrofuran or more suitably a halogenated solvent such as a fluorinated solvent or a chlorinated solvent and the like. Suitable reaction temperatures for any particular system can be readily determined empirically by those skilled in the art based on the present disclosure. A variety of free radical initiators may be employed. For example, azo compounds may be employed such as azo-bis-2,4-dimethylpentanenitrile. Peroxides, peresters, peracids and persulfates also could be employed. See Example 2 which follows for exemplary preferred reaction conditions and procedures.

Other monomers that can be reacted to provide a polymer of the invention can be identified by those skilled in the art. For example, to provide photoacid-labile units, suitable monomers include e.g. methacrylate or acrylate that contains the appropriate group substitution (e.g. tertiary alicyclic, t-butyl, etc.) on the carboxy oxygen of the ester group. Suitable acrylate monomers with tertiary alicyclic groups for synthesis of polymers useful in the resists of the invention also are disclosed in U.S. Patent 6,306,554 to Barclay et al. Maleic anhydride is a preferred reagent to provide fused anhydride polymer units. Vinyl lactones are also preferred reagents, such as alpha-butyrolactone.

Preferably a polymer of the invention will have a weight average molecular weight (Mw) of about 800 or 1,000 to about 100,000, more preferably about 2,000 to about 30,000, still more preferably from about 2,000 to 15,000 or 20,000, with a molecular weight distribution (Mw/Mn) of about 3 or less, more preferably a molecular weight distribution of about 2 or less. Molecular weights (either Mw or Mn) of the polymers of the invention are suitably determined by gel permeation chromatography.

Polymers of the invention used in chemically-amplified positive-acting photoresist formulations should contain a sufficient amount of photogenerated acid labile ester groups to enable formation of resist relief images as desired. For instance, suitable amount of such acid labile ester groups will be at least 1 mole percent of total units of the polymer, more preferably about 2 to 7 mole percent, still more typically about 3 to 30, 40, 50 or 60 mole percent of total polymer units.

As discussed above, the polymers of the invention are highly useful as a resin component in photoresist compositions, particularly chemically-amplified positive resists. Photoresists of the invention in general comprise a photoactive component and a resin binder component that comprises a polymer as described above.

The resin component should be used in an amount sufficient to render a coating layer of the resist developable with an aqueous alkaline developer.

The resist compositions of the invention also comprise a photoacid generator (i.e. "PAG") that is suitably employed in an amount sufficient to generate a latent image in a coating layer of the resist upon exposure to activating radiation. Preferred PAGs for imaging at 193 nm and 248 nm imaging include imidosulfonates such as compounds of the following formula: 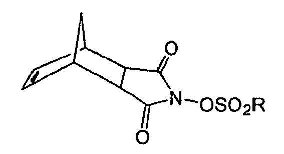 wherein R is camphor, adamantane, alkyl (e.g. C₁₋₁₂ alkyl) and fluoroalkyl such as fluoro(C₁₋₁₈alkyl) e.g. RCF₂- where R is optionally substituted adamantyl.

Also preferred is a triphenyl sulfonium PAG, complexed with anions such as the sulfonate anions mentioned above, particularly a perfluoroalkyl sulfonate such as perfluorobutane sulfonate.

Other known PAGS also may be employed in the resists of the invention. Particularly for 193 nm imaging, generally preferred are PAGS that do not contain aromatic groups, such as the above-mentioned imidosulfonates, in order to provide enhanced transparency.

Other suitable photoacid generators for use in compositions of the invention include for example: onium salts, for example, triphenylsulfonium trifluoromethanesulfonate, (p-tert-butoxyphenyl)diphenylsulfonium trifluoromethanesulfonate, tris(p-tert-butoxyphenyl)sulfonium trifluoromethanesulfonate, triphenylsulfonium p-toluenesulfonate;, nitrobenzyl derivatives, for example, 2-nitrobenzyl p-toluenesulfonate, 2,6-dinitrobenzyl p-toluenesulfonate, and 2,4-dinitrobenzyl p-toluenesulfonate; sulfonic acid esters, for example, 1,2,3-tris(methanesulfonyloxy)benzene, 1,2,3-tris(trifluoromethanesulfonyloxy)benzene, and 1,2,3-tris(p-toluenesulfonyloxy)benzene; diazomethane derivatives, for example, bis(benzenesulfonyl)diazomethane, bis(p-toluenesulfonyl)diazomethane; glyoxime derivatives, for example, bis-O-(p-toluenensulfonyl)-α-dimethylglyoxime, and bis-O-(n-butanesulfonyl)-α-dimethylglyoxime; sulfonic acid ester derivatives of an N-hydroxyimide compound, for example, N-hydroxysuccinimide methanesulfonic acid ester, N-hydroxysuccinimide trifluoromethanesulfonic acid ester; and halogen-containing triazine compounds, for example, 2-(4-methoxyphenyl)-4,6-bis(trichloromethyl)-1,3,5-triazine, and 2-(4-methoxynaphthyl)-4,6-bis(trichloromethyl)-1,3,5-triazine. One or more of such PAGs can be used.

A preferred optional additive of photoresist compositions of the invention is an added base, particularly tetrabutylammonium hydroxide (TBAH), or tetrabutylammonium lactate, which can enhance resolution of a developed resist relief image. For resists imaged at 193 nm, a preferred added base is a lactate salt of tetrabutylammonium hydroxide as well as various other amines such as triisopropanol, diazabicyclo undecene or diazabicyclononene. The added base is suitably used in relatively small amounts, e.g. about 0.03 to 5 percent by weight relative to the total solids.

Photoresists of the invention also may contain other optional materials. For example, other optional additives include anti-striation agents, plasticizers, speed enhancers, dissolution inhibitors, etc. Such optional additives typically will be present in minor concentrations in a photoresist composition except for fillers and dyes which may be present in relatively large concentrations, e.g., in amounts of from about 5 to 30 percent by weight of the total weight of a resist's dry components.

The photoresist of the invention can be readily prepared by those skilled in the art. For example, a photoresist composition of the invention can be prepared by dissolving the components of the photoresist in a suitable solvent such as, for example, 2-heptanone, cyclohexanone, ethyl lactate, ethylene glycol monomethyl ether, ethylene glycol monomethyl ether acetate, propylene glycol monomethyl ether; propylene glycol monomethyl ether acetate and 3-ethoxyethyl propionate. Typically, the solids content of the composition varies between about 1 and 35 percent by weight of the total weight of the photoresist composition. The resin binder and photoactive components should be present in amounts sufficient to provide a film coating layer and formation of good quality latent and relief images.

The photoresist compositions of the invention are used in accordance with generally known procedures. The liquid coating compositions of the invention are applied to a substrate such as by spinning, dipping, roller coating or other conventional coating technique. When spin coating, the solids content of the coating solution can be adjusted to provide a desired film thickness based upon the specific spinning equipment utilized, the viscosity of the solution, the speed of the spinner and the amount of time allowed for spinning.

The resist compositions of the invention are suitably applied to substrates conventionally used in processes involving coating with photoresists. For example, the composition may be applied over silicon wafers or silicon wafers coated with silicon dioxide for the production of microprocessors and other integrated circuit components. A substrate. A photoresist may be coated over another coating layer on the substrate, such as an organic or inorganic antireflective composition layer. Aluminum-aluminum oxide, gallium arsenide, ceramic, quartz, copper, glass substrates and the like are also suitably employed.

Following coating of the photoresist onto a surface, it is dried by heating to remove the solvent until preferably the photoresist coating is tack free. Thereafter, it is imaged through a mask in conventional manner. The exposure is sufficient to effectively activate the photoactive component of the photoresist system to produce a patterned image in the resist coating layer and, more specifically, the exposure energy typically ranges from about 1 to 100 mJ/cm², dependent upon the exposure tool and the components of the photoresist composition.

As discussed above, coating layers of the resist compositions of the invention are preferably photoactivated by a short exposure wavelength, particularly a sub-300 and sub-200 nm exposure wavelength. As discussed above, 193 nm is a particularly preferred exposure wavelength. However, the resist compositions of the invention also may be suitably imaged at higher wavelengths. For example, a resin of the invention can be formulated with an appropriate PAG and sensitizer if needed and imaged at higher wavelengths e.g. 248 nm or 365 nm.

Following exposure, the film layer of the composition is preferably baked at temperatures ranging from about 60°C to about 160°C. Thereafter, the film is developed. The exposed resist film is rendered positive working by employing a polar developer, preferably an aqueous based developer such as quaternary ammonium hydroxide solutions such as a tetra-alkyl ammonium hydroxide solution; various amine solutions preferably a 0.26 N tetramethylammonium hydroxide, such as ethyl amine, n-propyl amine, diethyl amine, di-n-propyl amine, triethyl amine, or methyldiethyl amine; alcohol amines such as diethanol amine or triethanol amine; cyclic amines such as pyrrole, pyridine, etc. In general, development is in accordance with procedures recognized in the art.

Following development of the photoresist coating over the substrate, the developed substrate may be selectively processed on those areas bared of resist, for example by chemically etching or plating substrate areas bared of resist in accordance with procedures known in the art. For the manufacture of microelectronic substrates, e.g., the manufacture of silicon dioxide wafers, suitable etchants include a gas etchant, e.g. a halogen plasma etchant such as a chlorine or fluorine-based etchant such a Cl₂ or CF₄/CHF₃ etchant applied as a plasma stream. After such processing, resist may be removed from the processed substrate using known stripping procedures.

The following non-limiting examples are illustrative of the invention.

### Example 1: ACPMA monomer synthesis

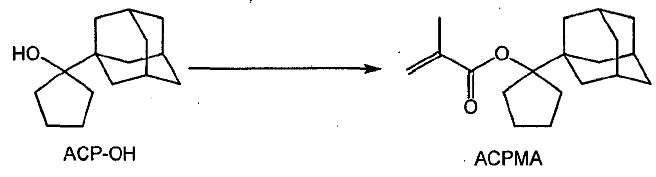

ACP-OH (150g) was dissolved in dry CH₂Cl₂ (0.2L). Methacryloyl chloride (100mL) was added. The solution was cooled in ice bath. A solution of dry triethylamine (236mL) and N,N-dimethylaminopyridine (3g) in dry CH₂Cl₂ (0.2L) was added dropwise over 4h. After the addition, the reaction mixture was slowly warmed to room temperature and stirred for 3 days. The reaction mixture was cooled in ice bath. Water (500mL) was added dropwise and the mixture was stirred for an additional 15min. Phases were separated. The organic layer was washed with water (1×100mL), HCl (0.3N, 2×100mL), NaHCO₃ (2×100mL), dried with Na₂SO₄, and concentrated to give a pale yellow solid. Recrystallization in heptane gave ACPMA (109g) as a white solid.

### Example 2: Synthesis of ACPMA/ECHMA/aGBLMA/ODOTMA/HAMA pentapolymer:

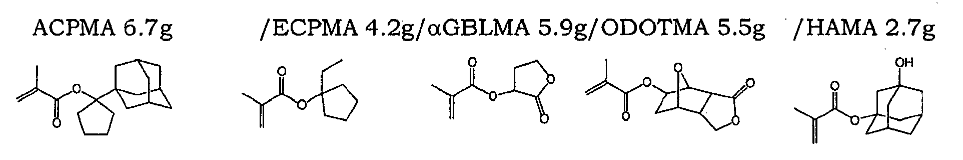

The above monomers were used in the following amounts: ACPMA: 6.57 gms; ECHMA: 4.2 gms; αGBLMA: 5.9 gms; ODOTMA: 5.5 gms; HAMA: 2.7 gms. These monomers in these amounts were dissolved in 15g of tetrahydrofuran and bubbled with nitrogen 5g of tetrahydrofuran and the V601 2.9 gms) initiator was weighted out into a separate flask. A round bottom flask was fitted with a condenser, nitrogen line, 5g of tetrahydrofuran added and heated to 70°C. The V601/tetrahydrofuran mixture was added and temp was allowed to return to 70°C. The monomer solution was then fed into the flask over 3.5 hr then held for 30 minutes. To the solution 15 ml of tetrahydrofuran was added and then cooled to room temp via an ice bath. The solution was then precipitated into 20x volume isopropyl alcohol, dried, redissolved into tetrahydrofuran ∼30% and then a second 20x volume isopropyl alcohol precipitation. The material was then dried over night at 45°C in a vacuum oven to yield 17.7g of white solid of the title pentapolymer.

### Example 3: Preparation and processing of a photoresist of the invention

A resist of the invention is prepared by admixing the following components where amounts are expressed as weight percent of solids (all components except solvent) and the resist is formulated by admixing the following components in the following amounts:

| Component | Amount |
|---|---|
| Resin | 0.8347 grams |
| PAG | 0.1314 grams |
| Basic Additive | 0.0152 grams |
| Solvent | propylene glycol monomethyl ether acetate (PGMEA): 7.0756 grams/methyl hydroxybutyrate: 11.79 grams/cyclohexanone: 4.71 grams |

In this photoresist composition, the resin is the polymer of Example 2 above. The PAG is triphenylsulfonium 3-hydroxyadamantyloxycarbonyldifluoromethanesulfonate. The basic additive is dodecyldiethanolamine.

The formulated resist composition is spin coated onto HMDS vapor primed silicon wafers and softbaked via a vacuum hotplate at 110°C for 60 seconds. The resist coating layer is exposed through a photomask at 193 nm, and then the exposed coating layers are post-exposure baked at 95°C for 60 seconds. The imaged resist layer is then developed by treatment with a 0.26N aqueous tetramethylammonium hydroxide solution.

The foregoing description of the invention is merely illustrative thereof, and it is understood that variations and modifications can be effected within the scope of the claims.

## Claims

1. A photoresist composition comprising a resin that comprises one or more polymerized units of the following structure: 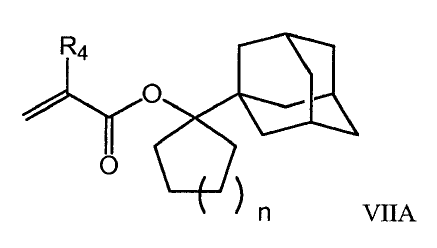 wherein R₄ represents hydrogen, straight, branched or cyclic monovalent hydrocarbon group of 1 to 6 carbon atoms, and n is an integer of 0 to 7.

2. A photoresist composition of claim 1 wherein the resin comprises one or more polymerized units of the following structure:

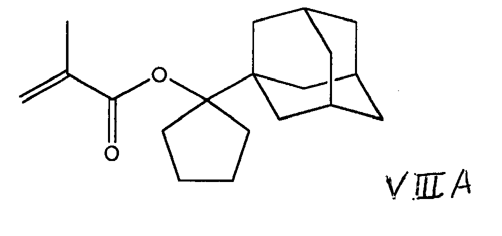

3. The photoresist composition of claim 1 or 2 where the resin is a copolymer, terpolymer, tetrapolymer or pentapolymer.

4. The photoresist composition of any one of claims 1 through 3 wherein the composition comprises one or more photoacid generator compounds.

5. The photoresist composition of any one of claims 1 through 4 wherein the resin comprises a second photoacid-labile group distinct from the ester group of the one or more polymerized units of structure VIIA or VIIIA.

6. A method for providing a photoresist relief image, comprising:
a) applying a coating layer of a photoresist composition of any one of claims 1 through 5 on a substrate; and
b) exposing the coating layer to activating radiation and developing the exposed coating layer.

## Patentansprüche

1. Eine Fotoresistzusammensetzung, beinhaltend ein Harz, das eine oder mehrere polymerisierte Einheiten der folgenden Struktur beinhaltet: 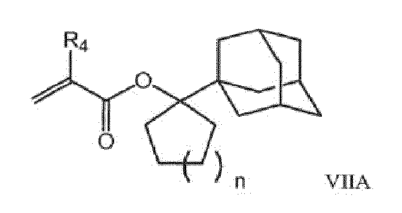 wobei R₄ Wasserstoff, eine gerade, verzweigte oder cyclische monovalente Kohlenwasserstoffgruppe mit 1 bis 6 Kohlenstoffatomen darstellt und n eine ganze Zahl von 0 bis 7 ist.

2. Fotoresistzusammensetzung gemäß Anspruch 1, wobei das Harz eine oder mehrere polymerisierte Einheiten der folgenden Struktur beinhaltet:

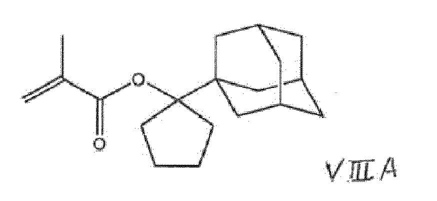

3. Fotoresistzusammensetzung gemäß Anspruch 1 oder 2, wobei das Harz ein Copolymer, Terpolymer, Tetrapolymer oder Pentapolymer ist.

4. Fotoresistzusammensetzung gemäß einem der Ansprüche 1 bis 3, wobei die Zusammensetzung eine oder mehrere Fotosäureerzeugerverbindungen beinhaltet.

5. Fotoresistzusammensetzung gemäß einem der Ansprüche 1 bis 4, wobei das Harz eine zweite fotosäurelabile Gruppe beinhaltet, die sich von der Estergruppe der einen oder der mehreren polymerisierten Einheiten der Struktur VIIA oder VIIIA unterscheidet.

6. Ein Verfahren zum Bereitstellen eines Fotoresistreliefbildes, beinhaltend:
a) Auftragen einer Überzugsschicht aus einer Fotoresistzusammensetzung gemäß einem der Ansprüche 1 bis 5 auf ein Substrat; und
b) Belichten der Überzugsschicht mit aktivierender Strahlung und Entwickeln der belichteten Überzugsschicht.

## Revendications

1. Une composition de résine photosensible comprenant une résine qui comprend une ou plusieurs unités polymérisées de la structure suivante : 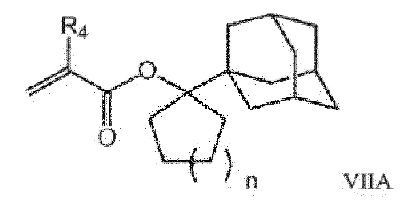 dans laquelle R₄ représente l'hydrogène, un groupe hydrocarbure monovalent, droit, ramifié ou cyclique de 1 à 6 atomes de carbone, et n est un nombre entier allant de 0 à 7.

2. Une composition de résine photosensible de la revendication 1 dans laquelle la résine comprend une ou plusieurs unités polymérisées de la structure suivante :

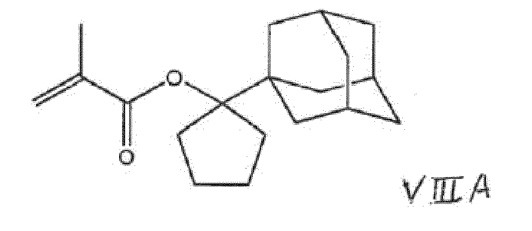

3. La composition de résine photosensible de la revendication 1 ou la revendication 2 où la résine est un copolymère, un terpolymère, un tétrapolymère ou un pentapolymère.

4. La composition de résine photosensible de l'une quelconque des revendications 1 à 3, la composition comprenant un ou plusieurs composés photogénérateurs d'acide.

5. La composition de résine photosensible de l'une quelconque des revendications 1 à 4 dans laquelle la résine comprend un deuxième groupe photolabile en milieu acide distinct du groupe ester de ces une ou plusieurs unités polimérisées de structure VIIA ou VIIIA.

6. Une méthode pour fournir une image en relief à partir de résine photosensible, comprenant :
a) l'application d'une couche de dépôt d'une composition de résine photosensible de l'une quelconque des revendications 1 à 5 sur un substrat ; et
b) l'exposition de la couche de dépôt à un rayonnement d'activation et le développement de la couche de dépôt exposée.
